# FASCICULE DE BREVET EUROPEEN

(11) **EP 1 672 689 B1**
(45) Date de publication et mention de la délivrance du brevet: **25.07.2007**
(21) Numéro de dépôt: 05112235.6
(22) Date de dépôt: 15.12.2005
(51) Int. Cl.: H01L 21/8244, H01L 21/02, H01L 27/11

(54) **Cellule mémoire SRAM**
SRAM-Speicherzelle
SRAM memory cell

(30) Priorité: 16.12.2004 FR 0453012
(43) Date de publication de la demande: 21.06.2006
(73) Titulaire: STMicroelectronics ( Crolles 2) SAS, 38920 Crolles (FR)
(72) Inventeur: Borot, Bertrand, 38570 Le Cheylas (FR); Coronel, Philippe, 38530 Barraux (FR)
(74) Mandataire: de Beaumont, Michel

(56) Documents cités:
- US-A- 4 377 819
- US-A- 5 825 684

## Description

### Domaine de l'invention

La présente invention concerne, de façon générale, les mémoires vives et leur réalisation sous forme monolithique dans un substrat semiconducteur. Plus particulièrement, la présente invention concerne des mémoires à accès aléatoire statique (SRAM).

### Exposé de l'art antérieur

On a proposé de réaliser des réseaux mémoire SRAM à partir de la répétition d'une cellule élémentaire comportant quatre transistors et deux résistances.

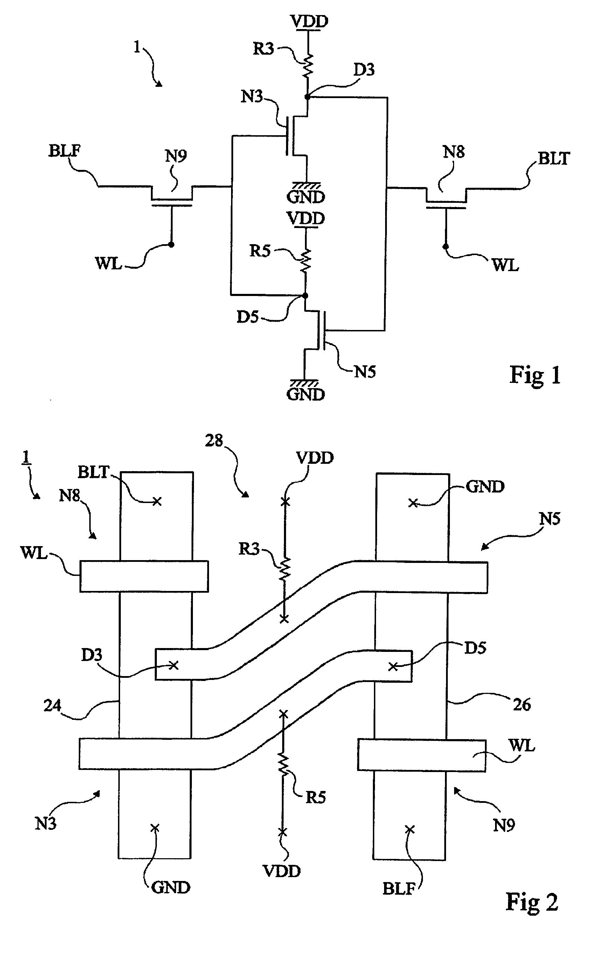

La figure 1 est un schéma électrique d'une telle cellule 1. La cellule 1 comporte deux associations en série R3-N3 et R5-N5 d'une résistance R3, R5 et d'un transistor MOS à canal N N3, N5. Les résistances R3 et R5 sont identiques. Les transistors N3 et N5 sont identiques. Chaque association en série R3-N3 et R5-N5 est connectée entre un rail d'alimentation haut Vdd, par l'extrémité libre de la résistance R3 ou R5, et un rail d'alimentation de référence basse ou masse GND, par la source du transistor N3 ou N5. Le point milieu d'une première association R3-N3, c'est-à-dire le drain D3 du transistor N3, est interconnecté à la grille du transistor N5 de la seconde association R5-N5. Le point d'interconnexion D3 est relié à une ligne de bit BLT par l'intermédiaire d'un transistor MOS à canal N d'écriture/lecture N8 dont la grille est reliée à la ligne de mot WL de la cellule 1. Le point D3 est alors le point milieu de la connexion en série, entre la ligne de bit BLT et la masse GND, des transistors N8 et N3. De façon symétrique, le point milieu D5 de la seconde association R5-N5 est interconnecté en un point P à la grille du transistor N3 de l'autre association R3-N3. Le point d'interconnexion P est relié à une ligne de bit inverse BLF par l'intermédiaire d'un transistor MOS à canal N d'écriture/lecture N9 dont la grille est reliée à la ligne de mot WL de la cellule 1. Le point D5 est alors le point milieu de la connexion en série, entre la ligne de bit inverse BLF et la masse GND, des transistors N9 et N5.

La figure 2 illustre, en vue de dessus partielle et schématique, une réalisation sous forme monolithique de la cellule 1. Les deux transistors N3 et N8 ayant un drain commun D3 sont réalisés dans une même région active de type N 24. De même, les deux transistors N5 et N9 ayant un drain commun D5 sont réalisés dans une même région active de type N 26. Les régions actives 24 et 26 sont représentées sous la forme de rectangles dont la longueur s'étend selon la direction verticale de la figure 2. Les régions actives 24 et 26 sont séparées par une zone d'isolement 28. Les deux grilles isolées des transistors N8 et N3 divisent la région 24 en trois parties. La partie haute constitue la source du transistor N8 reliée à la ligne de bit BLT. La partie basse constitue la source du transistor N3 reliée à la masse GND. La grille isolée haute du transistor N8 constitue une ligne de mot WL de la cellule 1. La partie centrale de la région 24 constitue le drain commun des transistors N3 et N8 solidaire d'une métallisation D3.

De façon symétrique, dans la région 26 sont formés, entre un contact de masse GND et un contact de ligne de bit inverse BLF, la source du transistor N5, le drain commun D5 des transistors N9 et N5 et la source du transistor N9. La grille du transistor N9 est une ligne de mot WL. La grille du transistor N5 est reliée au drain D3 par la résistance R3. Le drain D5 est relié par une métallisation à la grille du transistor N3.

La résistance R3 est formée entre la métallisation D3 et un contact d'alimentation haute Vdd. La résistance R5 est formée entre la métallisation D5 et un contact d'alimentation haute Vdd. Les résistances R3 et R5 sont classiquement réalisées dans le substrat sous la forme de caissons faiblement dopés ou dans les niveaux de métallisation d'interconnexion sous la forme de pistes métalliques.

Pour garantir une faible consommation de la mémoire constituée par la répétition de la cellule 1, il convient que la résistance totale connectée à l'alimentation Vdd, c'est-à-dire que la valeur des résistances R3 et R5, soit très élevée, de l'ordre d'une centaine de mégohms (MΩ), ou plus.

De telles valeurs rendent les résistances R3 et R5 très encombrantes, car les caissons ou les pistes qui les constituent ont alors des surfaces d'intégration importantes.

On préfère donc actuellement utiliser des réseaux mémoire SRAM constitués de cellules élémentaires à six transistors dont quatre à canal N et deux à canal P. Chaque cellule élémentaire est alors réalisée dans quatre régions actives, deux régions comportant chacune deux transistors à canal N et les deux autres comportant chacune un transistor à canal P.

Il serait souhaitable de réduire encore les dimensions de la cellule élémentaire pour accroître la densité des mémoires SRAM.

La présente invention vise à proposer une telle cellule SRAM.

La présente invention vise également à proposer une telle cellule dont la consommation soit réduite.

### Résumé de l'invention

Pour atteindre ces objets, la présente invention prévoit une cellule mémoire SRAM à quatre transistors et deux résistances réalisée dans un substrat semiconducteur, les transistors étant réalisés par paires dans deux régions actives du substrat, les résistances étant réalisées par des condensateurs ayant des fuites, une première électrode des condensateurs étant commune et constituée d'une ligne d'alimentation haute de la cellule enterrée dans une zone séparant les régions actives.

La présente invention prévoit également une cellule dont les transistors sont des transistors MOS à canal N ayant une région de drain commune.

La présente invention prévoit également une cellule dont la seconde électrode de chaque condensateur est connectée par une même métallisation à une région de drain commune d'une région active et à la grille d'un transistor de l'autre région active dont la source est connectée à une ligne d'alimentation basse (GND) de la cellule.

La présente invention prévoit également une cellule dont la première électrode est une couche de nitrure de titane d'une épaisseur de 50 à 100 nm.

### Brève description des dessins

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 est un schéma électrique d'une cellule SRAM à quatre transistors et deux résistances connue ;
la figure 2 illustre, en vue de dessus partielle et schématique, un mode de réalisation connu de la cellule de la figure 1 ;
la figure 3 illustre, en vue de dessus partielle et schématique, un mode de réalisation d'une cellule SRAM à quatre transistors selon la présente invention ; et
les figures 4A à 4D illustrent, en vue en coupe partielle et schématique, des étapes d'un procédé de fabrication d'une partie de la cellule SRAM de la figure 3.

### Description détaillée

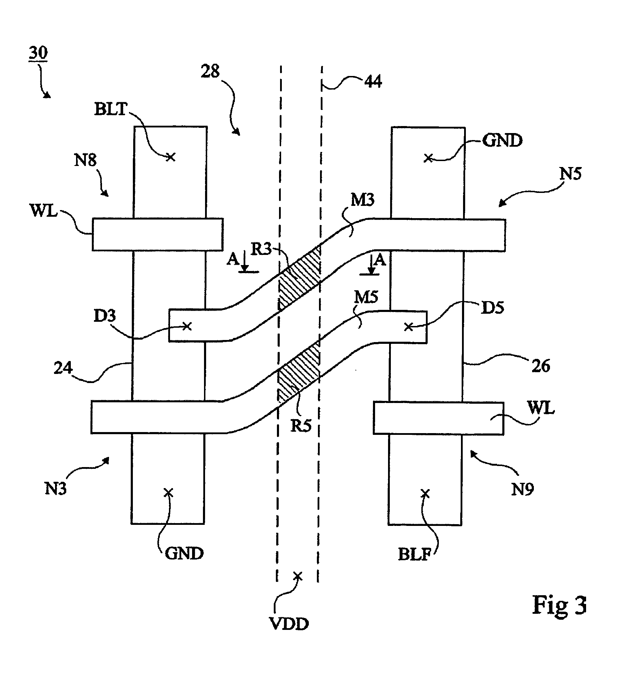

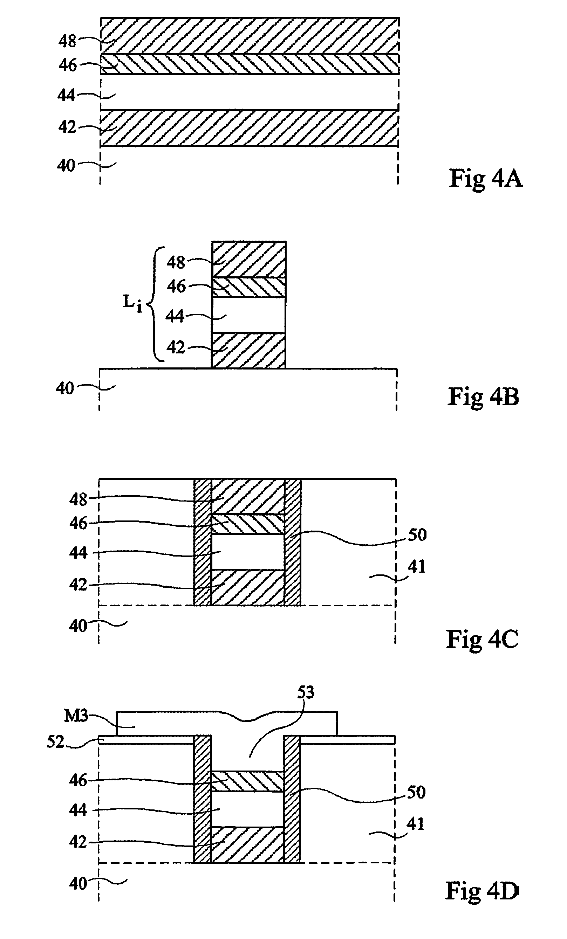

Par souci de clarté, les mêmes éléments ont été désignés par les mêmes références aux différentes figures et, de plus, comme cela est habituel dans la représentation des circuits intégrés, les vues de dessus des figures 2 et 3 ainsi que les vues en coupe des figures 4A à 4D ne sont pas tracées à l'échelle.

Les inventeurs proposent de réduire la surface d'intégration de la cellule à quatre transistors et deux résistances à une valeur inférieure à celle d'une cellule à six transistors.

Pour ce faire, les inventeurs proposent d'utiliser une nouvelle structure d'intégration dans laquelle les résistances R3 et R5 de la figure 1 sont réalisées non plus sous la forme de caissons dans un substrat, ni sous la forme de pistes métalliques, mais par les fuites d'un condensateur de faible capacité formé dans la zone d'isolement séparant les deux régions actives dans lesquelles sont formés les transistors de la cellule.

La figure 3 illustre, en vue de dessus partielle et schématique, une cellule SRAM 30 selon un mode de réalisation de la présente invention.

Les transistors N3, N5, N8 et N9 sont réalisés comme dans la structure de la figure 2 par paires N3 et N8, N5 et N9 dans deux régions actives 24 et 26.

Une ligne enterrée 44, illustrée en traits pointillés, passe dans la région 28 séparant les deux régions actives 24 et 26. La ligne enterrée 44 est destinée à constituer le rail d'alimentation haute Vdd de la figure 1. La ligne 44 croise les métallisations M3 et M5 reliant respectivement le drain D3 à la grille du transistor N5 et le drain D5 à la grille du transistor N3.

Les résistances R3 et R5 sont formées par des condensateurs à fortes fuites situés aux emplacements des croisements, illustrés par des hachures en figure 3. Les condensateurs-résistances sont formés verticalement dans la zone d'isolement 28 de telle sorte que la ligne 44 - alimentation Vdd - constitue une première électrode commune des condensateurs. La deuxième électrode des condensateurs-résistances contacte la métallisation de drain D3 ou D5 du transistor associé N3 ou N5, respectivement.

Les figures 4A à 4D sont des vues en coupe selon l'axe A-A de la figure 3 illustrant des étapes de fabrication de la résistance R3 selon un mode de réalisation de la présente invention.

Comme l'illustre la figure 4A, le procédé commence par les dépôts successifs sur un substrat semiconducteur monocristallin 40, par exemple du silicium, d'une couche isolante 42, d'une couche conductrice 44, par exemple de nitrure de titane, d'une couche diélectrique 46 dont la structure sera détaillée ultérieurement et d'une couche isolante 48. Comme cela ressortira de la description suivante, l'épaisseur de la couche isolante 42 est choisie pour garantir un isolement entre le substrat sous-jacent 40 et la couche conductrice superposée 44, sans couplage capacitif entre le substrat 40 et la couche 44.

Aux étapes suivantes, on grave sélectivement à l'aide d'un même masque l'empilement des quatre couches 48, 46, 44 et 42 de façon à ne les laisser en place que selon des lignes parallèles. Entre deux telles lignes, le substrat 40 est découvert. La figure 4B illustre une telle ligne Lᵢ.

Comme l'illustre la figure 4C, le procédé se poursuit par le dépôt sur les parois verticales de la ligne Lᵢ d'un espaceur isolant 50. Ensuite, on fait croître par épitaxie sélective une couche monocristalline 41 sur le substrat 40, de part et d'autre de la ligne Lᵢ, jusqu'à ce que la surface supérieure de la couche 41 soit coplanaire avec le sommet de la ligne Lᵢ, c'est-à-dire la surface supérieure de la couche isolante 48. La nature et l'épaisseur de l'espaceur 50 sont choisies de façon à éviter tout couplage capacitif entre la couche conductrice 44 et le substrat 40-41. La couche épitaxiale 41 pourra être de même nature et dopage que le substrat 40 ou bien elle pourra être optimisée pour des raisons qui apparaîtront à l'homme de l'art.

Aux étapes suivantes, illustrées en figure 4D, on élimine des portions de la couche isolante 48 de façon à découvrir localement la couche diélectrique 46 en des emplacements déterminés (là où on veut former des résistances-condensateurs). Ensuite, on forme une couche isolante à la surface du substrat 40. On dépose de façon conforme et on grave une couche conductrice, par exemple en silicium polycristallin, qui correspond à la métallisation M3 de la figure 3. Après sa gravure, la couche 53 reste en place dans les ouvertures formées par le retrait partiel de la couche isolante 48 et s'étend depuis chacune de ces ouvertures sur le substrat 40.

On a ainsi formé un condensateur dont une première électrode est la ligne 44, le diélectrique la couche 46 et la deuxième électrode la métallisation M3. La nature et la formation de la couche diélectrique 46 sont choisies de façon que le condensateur présente des fuites importantes, c'est-à-dire une résistance parasite élevée de l'ordre de la centaine de mégohms (MΩ) alors que sa capacité est négligeable. L'ensemble de la ligne 44, du diélectrique 46 et de la métallisation M3 constitue alors une résistance.

On comprendra en se référant à la vue de dessus de la figure 3 qu'à l'étape décrite en relation avec la figure 4D la couche isolante supérieure 48 n'est retirée et remplacée par une électrode qu'aux seuls emplacements de formation des résistances R3 et R5 de la cellule 1 au niveau des intersections entre la ligne 44 d'alimentation Vdd et les interconnexions métalliques formant les points D3 et D5 de la figure 1. En dehors de ces emplacements, la structure demeure telle que décrite en relation avec la figure 4C, assurant la continuité de la ligne enterrée 44 reliée à l'alimentation Vdd.

On n'a pas décrit ci-dessus les étapes classiques de réalisation de zones actives dans le substrat. Ces étapes prendront place après réalisation de la couche épitaxiale 41.

Un avantage d'une telle cellule mémoire réside dans le fait que, par rapport à une cellule mémoire à quatre transistors et deux résistances classique, elle présente une surface d'intégration bien moindre. Plus particulièrement, la surface d'intégration des résistances R3 et R5 est considérablement réduite.

De plus, la surface occupée par la cellule mémoire à quatre transistors et deux résistances selon la présente invention est inférieure à la surface occupée par une cellule mémoire classique à six transistors. En effet, par rapport à la structure classique de la figure 2, la cellule mémoire de la figure 3 requiert une zone active et une zone d'isolement de moins. Étant donnée une filière technologique, dans laquelle les dimensions minimales des lignes et vias sont fixées, la cellule SRAM de la figure 3 présente une surface de 25 % inférieure à celle de la cellule classique de la figure 2.

Un autre avantage de la structure selon la présente invention réside dans l'enterrement du rail d'alimentation Vdd 44 sous les résistances R3 et R5. En effet, dans les structures classiques, notamment la structure à six transistors, il faut prévoir de former le rail d'alimentation dans un niveau de métallisation superposé au substrat semiconducteur. Réaliser le rail d'alimentation Vdd directement dans le substrat permet de réduire le nombre de niveaux de métallisation, ou de bénéficier d'espace supplémentaire dans les niveaux de métallisations. Cela permet et/ou simplifie avantageusement la réalisation dans les niveaux de métallisation d'éléments associés à la mémoire SRAM.

Bien entendu, la présente invention est susceptible de diverses variantes et modifications qui apparaîtront à l'homme de l'art. Notamment, les formes en vue de dessus des lignes Lᵢ et/ou des ouvertures de retrait de la couche isolante 48 (figure 4D) pourront être choisies pour optimiser les valeurs des résistances recherchées.

En outre, l'homme de l'art saura reproduire la cellule décrite pour former un réseau mémoire constitué de centaines de milliers de telles cellules.

En outre, on pourra choisir pour les diverses couches mentionnées les matériaux et épaisseurs suivants :
couche isolante 42 : couche d'oxyde de silicium (SiO₂) de 150 à 250 nm d'épaisseur ;
couche conductrice 44 : couche de nitrure de titane de 50 à 150 nm ;
couche diélectrique 46 : couche de 3 à 30 nm d'épaisseur, d'un quelconque isolant tel que l'oxyde de silicium, le nitrure de silicium (Si₃N₄), l'oxynitrure de silicium (SiON), ou tout autre isolant choisi parmi les isolants utilisés dans la réalisation de circuits intégrés, notamment des isolants à permittivité diélectrique élevée ;
couche isolante 48 : couche d'oxyde de silicium, de préférence du type TEOS, de 100 à 200 nm d'épaisseur ;
espaceur 50 : couche de nitrure de silicium (Si₃N₄) ou d'oxynitrure de silicium (SiON) de 30 à 100 nm d'épaisseur ; et
couche isolante 52 : couche d'oxyde de silicium, de préférence du type TEOS ou HDP, de 500 à 800 nm d'épaisseur.

Ces indications sont données uniquement à titre d'exemple et l'homme de l'art saura choisir les matériaux et leurs épaisseurs nécessaires dans une filière technologique donnée. En particulier, l'homme de l'art saura choisir un diélectrique 46 présentant un taux de fuite propre à transformer le condensateur 44-46-53 en une résistance présentant un très faible caractère capacitif, négligeable.

Par ailleurs, on notera que par substrat on désigne autant une tranche de silicium uniformément dopée, que des zones épitaxiées et/ou spécifiquement dopées par diffusion/implantation formées sur ou dans un substrat massif.

De façon générale, bien que la présente invention a été décrite dans le cadre d'une filière de silicium elle s'applique à toute filière de fabrication de circuits intégrés.

## Revendications

1. Cellule mémoire SRAM (30) à quatre transistors (N3, N5, N8, N9) et deux résistances (R3, R5) réalisée dans un substrat semiconducteur (40), les transistors étant réalisés par paires (N3-N8, N5-N9) dans deux régions actives (24, 26) du substrat, dans laquelle les résistances sont réalisées par des condensateurs (44, 46, 53) ayant des fuites, une première électrode (44) des condensateurs étant commune et constituée d'une ligne d'alimentation haute (Vdd) de la cellule enterrée dans une zone (28) séparant lesdites régions actives.

2. Cellule selon la revendication 1, dans laquelle les transistors (N3, N8 ; N5, N9) des deux paires sont des transistors MOS à canal N ayant une région de drain (D3 ; D5) commune.

3. Cellule selon la revendication 2, dans laquelle la seconde électrode (53) de chaque condensateur est connectée par une même métallisation (M3) à une région de drain commune (D3 ; D5) d'une région active et à la grille d'un transistor (N5 ; N3) de l'autre région active dont la source est connectée à une ligne d'alimentation basse (GND) de la cellule.

4. Cellule selon la revendication 2 ou 3, dans laquelle la première électrode (44) est une couche de nitrure de titane d'une épaisseur de 50 à 100 nm.

## Claims

1. An SRAM cell (30) with four transistors (N3, N5, N8, N9) and two resistors (R3, R5) formed in a semiconductor substrate (40), the transistors being formed in pairs (N3-N8, N5-N9) in two active regions (24, 26) of the substrate, wherein the resistors are formed by leakage capacitors (44, 46, 53), a first electrode (44) of the capacitors being common and formed of a high supply line (Vdd) of the cell buried in an area (28) separating the active regions.

2. An SRAM cell according to claim 1, wherein the transistors (N3, N8; N5, N9) of both pairs are N-channel MOS transistors having a common drain region (D3, D5).

3. An SRAM cell according to claim 2, wherein the second electrode (53) of each capacitor is connected through a single metallization (M3), on one hand, to a common drain region (D3, D5) of a first active region and, on the other hand, to a gate of a transistor (N5, N3) of a second active region whose source terminal is to be connected to a low supply line (GND) of the cell.

4. An SRAM cell according to claim 2 or 3, wherein the first electrode (44) of the capacitor is a titanium nitride layer having a thickness of 50 to 100 nm.

## Patentansprüche

1. Eine SRAM-Zelle (30) mit vier Transistoren (N3, N5, N8, N9) und zwei Widerständen (R3, R5) ausgebildet in einem Halbleiter-Substrat (40), wobei die Transistoren in Paaren (N3-N8, N5-N9) in zwei aktiven Zonen oder Regionen (24, 26) des Substrats gebildet sind, wobei die Widerstände durch Leckkondensatoren (44, 46, 53) gebildet werden, wobei ferner eine erste Elektrode (44) der Kondensatoren gemeinsam ist und ausgebildet ist und gebildet ist durch eine Versorgungsleitung hoher Spannung (Vdd) der Zelle vergraben in einer die aktiven Regionen trennenden Fläche (28).

2. Eine SRAM-Zelle gemäß Anspruch 1, wobei die Transistoren (N3, N8; N5, N9) von beiden Paaren N-Kanal MOS-Transistoren sind mit einer gemeinsamen Drain-Region (D3, D5).

3. Eine SRAM-Zelle gemäß Anspruch 2, wobei die zweite Elektrode (53) jedes Kondensators über einer einzigen Metallisierung (M3) einerseits mit einer gemeinsamen Drain-Region (D3, D5) einer ersten aktiven Region und andererseits mit einem Gate eines Transistors (N5, N3) einer zweiten aktiven Region verbunden ist, deren Source-Anschluss mit einer Versorgungsleitung niedriger Spannung (GND) der Zelle zu verbinden ist.

4. Eine SRAM-Zelle gemäß Anspruch 2 oder 3, wobei die erste Elektrode (44) des Kondensators eine Titan-Nitrit-Schicht ist, und zwar mit einer Dicke von 50 bis 100 nm
